(19) Europäisches Patentamt
European Patent Office
Office européen des brevets

(11) **EP 4 692 875 A1**

(12) **EUROPEAN PATENT APPLICATION**
published in accordance with Art. 153(4) EPC

(43) Date of publication:
**11.02.2026 Bulletin 2026/07**

(21) Application number: **24788676.5**

(22) Date of filing: **05.04.2024**

(51) International Patent Classification (IPC):
*G02B 6/293* (2006.01)        *G01J 3/12* (2006.01)
*G02B 6/26* (2006.01)         *G02B 6/42* (2006.01)
*G02B 6/287* (2006.01)        *H01S 5/0687* (2006.01)

(52) Cooperative Patent Classification (CPC):
**G01J 3/12; G02B 6/26; G02B 6/287; G02B 6/293;
G02B 6/42; H01S 5/0687**

(86) International application number:
**PCT/JP2024/014140**

(87) International publication number:
**WO 2024/214652 (17.10.2024 Gazette 2024/42)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **11.04.2023 JP 2023064294**

(71) Applicant: **Hamamatsu Photonics K.K.
Hamamatsu-shi, Shizuoka 435-8558 (JP)**

(72) Inventor: **NAKAMURA Tomonori
Hamamatsu-shi, Shizuoka 435-8558 (JP)**

(74) Representative: **Hoffmann Eitle
Patent- und Rechtsanwälte PartmbB
Arabellastraße 30
81925 München (DE)**

(54) **OPTICAL ELEMENT, WAVELENGTH DETECTION UNIT, AND LIGHT GENERATION UNIT**

(57) An optical fiber coupler 5 is an optical element for separating light whose wavelength is to be measured, and includes a first optical fiber 20 allowing light having a predetermined center wavelength to propagate, and a second optical fiber 30 having a coupling region 50 coupled to the first optical fiber 20, in which the center wavelength of the light allowed to propagate through the first optical fiber 20 is a wavelength at which a transmittance in the coupling region 50 is within a range of 10% to 90%, and the light is transmitted and reflected according to a wavelength in the coupling region 50.

*Fig.1*

**Description**

**Technical Field**

One aspect of the present disclosure relates to an optical element, a wavelength detection unit, and a light generation unit.

**Background Art**

Patent document 1 describes an optical transmitter including a wavelength-tunable light source, an etalon filter that filters output light from the wavelength-tunable light source, a measurement unit that generates a monitor value corresponding to the output optical power of the etalon filter, and a control unit that adjusts a wavelength of the output light from the wavelength-tunable light source by controlling a temperature of the wavelength-tunable light source, and adjusts transmission characteristics of the etalon filter by controlling a temperature of the etalon filter.

**Citation List**

**Patent Literature**

[Patent Literature 1] Japanese Unexamined Patent Publication No. 2016-129207

**Summary of Invention**

**Technical Problem**

In a configuration that adjusts a wavelength of light output from a light source, or the like, it is important to derive (estimate) wavelength information of the light output from the light source with high accuracy. In this regard, for light whose spectrum does not have a plurality of peaks, or the like, it may be difficult to derive wavelength information with high accuracy.

One aspect of the present disclosure has been made in view of the above circumstances, and an objective thereof is to appropriately derive wavelength information regardless of a shape of a spectrum.

**Solution to Problem**

An optical element according to one aspect of the present disclosure is an optical element for separating light whose wavelength is to be measured, and includes a first optical fiber allowing light having a predetermined center wavelength to propagate, and a second optical fiber having a coupling region coupled to the first optical fiber, in which the center wavelength of the light allowed to propagate through the first optical fiber is a wavelength at which a transmittance in the coupling region is within a range of 10% to 90%, and the light is transmitted and reflected according to a wavelength of the light allowed to propagate through the first optical fiber in the coupling region.

In the optical element according to one aspect of the present disclosure, the first optical fiber and the second optical fiber are coupled in the coupling region, a transmittance in the coupling region for the center wavelength of the light propagated through the first optical fiber is in a range of 10% to 90%, and in the coupling region, the light is transmitted and reflected according to the wavelength of the light that can be propagated through the first optical fiber. In this way, when the center wavelength of the light propagating through the first optical fiber is set to a wavelength at which the transmittance in the coupling region is within a range of 10% to 90%, and the light is transmitted and reflected in the coupling region according to the wavelength, the light is separated into the first optical fiber side and the second optical fiber side according to the wavelength. According to such a configuration, since the light separated according to the wavelength propagates through the first optical fiber side and the second optical fiber side, respectively, wavelength information can be appropriately derived by, for example, measuring the light on the first optical fiber side and the second optical fiber side. Then, in this method of deriving wavelength information on the basis of the light separated by such an optical element, it is possible to derive the wavelength information regardless of a shape of the spectrum, for example, even for light whose spectrum has a plurality of peaks, or the like. As described above, according to the optical element according to one aspect of the present disclosure, it is possible to appropriately derive wavelength information of various types of light regardless of a shape of the spectrum.

The center wavelength of the light allowed to propagate through the first optical fiber may be a wavelength at which a transmittance in the coupling region is within a range of 15% to 85%. In an optical fiber coupler in which the two optical fibers have the coupling region as described above, a relationship between the wavelength and the transmittance (and the reflectance) is shown by a sine curve in a graph in which, for example, the horizontal axis represents the wavelength and the vertical axis represents the transmittance (and the reflectance). In such a sine curve, the wavelength information is appropriately derived on the basis of the transmittance and reflectance in a range in which the relationship is linear. In this regard, for example, if the transmittance is within the wavelength range of 15% to 85%, a slope of the sine curve in that range is more than half of a slope of the sine curve when the transmittance is 50%, and therefore the above-described relationship becomes relatively linear, allowing wavelength information to be derived with high accuracy.

The center wavelength of the light allowed to propagate through the first optical fiber may be a wavelength at which the transmittance in the coupling region is within a range of 20% to 80%, According to such a configuration, the wavelength information can be derived with higher accuracy in a range in which the relationship between the transmittance (and the reflectance) and the wavelength is more linear.

A wavelength detection unit according to one aspect of the present disclosure includes the optical element described above, a first point sensor optically coupled to the first optical fiber of the optical element, and a second point sensor optically coupled to the second optical fiber of the optical element. Thus, when the point sensor is optically coupled to each optical fiber, light transmitted through and light reflected from the coupling region can be accurately detected at each point. Thereby, wavelength information can be appropriately derived.

The wavelength detection unit described above may further include a processing unit which derives and outputs wavelength information on the basis of a signal output from the first point sensor and a signal output from the second point sensor. According to such a configuration, wavelength information can be derived with high accuracy on the basis of information on the transmitted light and reflected light detected with high accuracy at the respective points.

A light generation unit according to one aspect of the present disclosure includes a light source unit having a light source and a power supply operating the light source, and configured to output light having a predetermined center wavelength, the wavelength detection unit described above optically coupled to the light source by the first optical fiber, and a control unit controlling the center wavelength of the light output from the light source unit on the basis of a signal output from the first point sensor and a signal output from the second point sensor. In this way, when the center wavelength of the light output from the light source unit is controlled on the basis of information on the transmitted light and reflected light detected with high accuracy at the respective points, the center wavelength of the light output from the light source unit can be adjusted with high accuracy from the actually measured information on the transmitted light and reflected light.

The control unit may be a circuit that performs feedback control of the center wavelength on the basis of the signal output from the first point sensor and the signal output from the second point sensor. When the feedback control is performed in this way, actually measured information on the transmitted light and reflected light can be appropriately reflected in the adjustment of the center wavelength, thereby further improving an adjustment accuracy of the center wavelength.

In the light generation unit described above, the light source unit, the wavelength detection unit, and the control unit may be configured as a photonic integrated circuit. Thereby, the configuration relating to the light generation unit can be made small in size.

A wavelength detection unit according to one aspect of the present disclosure includes a dichroic mirror separating light input from a first optical path by transmitting and reflecting the light according to a wavelength, a first point sensor detecting the light transmitted through the dichroic mirror, and
a second point sensor detecting the light reflected by the dichroic mirror into a second optical path different from the first optical path, in which the dichroic mirror exhibits a monotonic change in transmittance and reflectance with respect to the wavelength in a predetermined wavelength range. In the wavelength detection unit according to one aspect of the present disclosure, the dichroic mirror transmits and reflects input light according to the wavelength, and the transmittance and reflectance of the dichroic mirror change monotonically within a predetermined wavelength range. Then, the light transmitted through the dichroic mirror is detected by the first point sensor, and the light reflected by the dichroic mirror into an optical path different from the optical path of the input light is detected by the second point sensor. According to such a configuration, the light separated by the dichroic mirror according to the wavelength (transmitted light and reflected light) is detected by the first point sensor and the second point sensor, respectively. In this way, when the light separated according to the wavelength is detected with high accuracy, it is possible to appropriately derive wavelength information on the basis of the detection results. Then, in the method of deriving wavelength information on the basis of the light separated as described above, it is possible to derive the wavelength information regardless of a shape of the spectrum, for example, even for light whose spectrum has a plurality of peaks, or the like. As described above, according to the wavelength detection unit according to one aspect of the present disclosure, it is possible to appropriately derive wavelength information of various types of light regardless of a shape of the spectrum.

The wavelength detection unit may further include a processing unit which derives and outputs wavelength information on the basis of a signal output from the first point sensor and a signal output from the second point sensor. According to such a configuration, wavelength information can be derived with high accuracy on the basis of information on the transmitted light and reflected light detected with high accuracy at the respective points.

A light generation unit according to one aspect of the present disclosure includes a light source unit having a light source and a power supply operating the light source, and outputting light having a predetermined center wavelength, the wavelength detection unit described above into which the light from the light source unit is input, and a control unit controlling the center wavelength of the light output from the light source unit on the basis of a signal output from the first point sensor and a signal output from the second point sensor. In this way, when the center wavelength of the light output from the light source unit is controlled on the basis of information on the transmitted light and reflected light detected with high accuracy at the respective points, the center wavelength of the light output from the light source unit can be adjusted with high accuracy from the actually measured information on the transmitted light and reflected light.

**Advantageous Effects of Invention**

According to one aspect of the present disclosure, it is possible to appropriately derive wavelength information of various types of light regardless of a shape of a spectrum.

**Brief Description of Drawings**

FIG. 1 is a diagram schematically showing a wavelength detection unit according to the present embodiment.
FIG. 2 is a diagram showing an example of wavelength characteristics of an optical fiber coupler.
FIG. 3 is a diagram schematically showing a light generation unit including the wavelength detection unit shown in FIG. 1.
FIG. 4 is a diagram showing an example of an analog feedback circuit.
FIG. 5 is a diagram schematically showing a light generation unit according to a modified example.
FIG. 6 is a diagram showing an example of a spectrum of light and wavelength characteristics of a tilted dichroic mirror.
FIG. 7 is a diagram showing an application example of a wavelength detection unit.
FIG. 8 is a diagram showing an application example of a wavelength detection unit.
FIG. 9 is a diagram showing an application example of a wavelength detection unit.
FIG. 10 is a diagram showing an application example of a wavelength detection unit.
FIG. 11 is a diagram showing an application example of a wavelength detection unit.

**Description of Embodiments**

Hereinafter, an embodiment of the present invention will be described in detail with reference to the drawings. Further, in each of the drawings, the same or corresponding portions will be denoted by the same reference signs, and duplicate description thereof will be omitted.

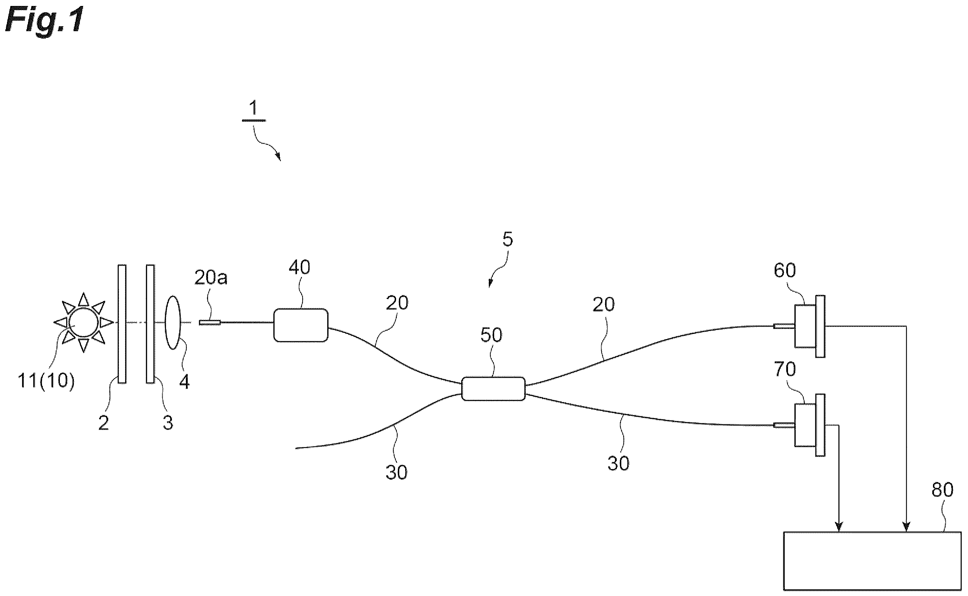

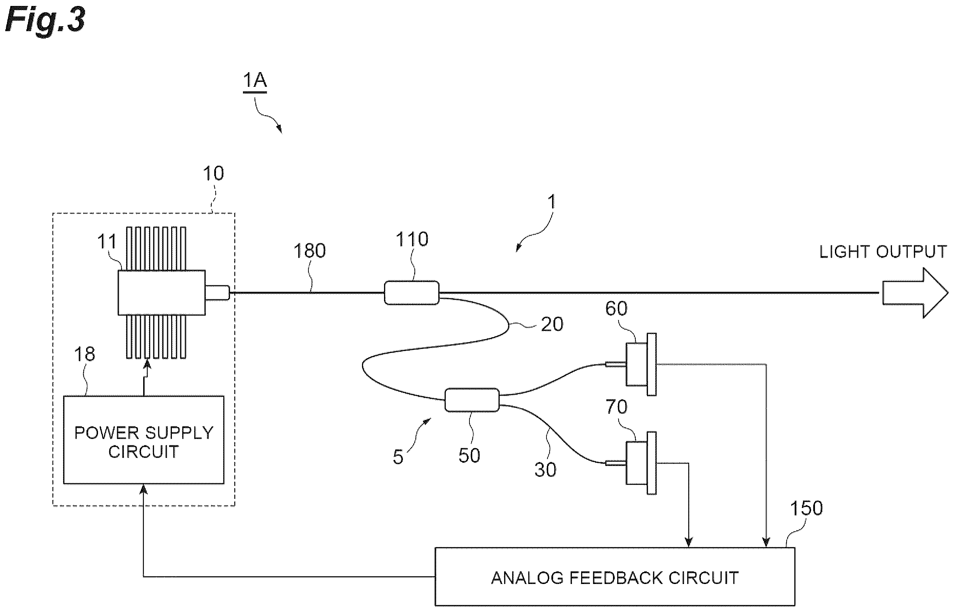

FIG. 1 is a diagram schematically showing a wavelength detection unit 1 according to the present embodiment. The wavelength detection unit 1 is configured to detect (derive) wavelength information of light output from a light source 11 included in a light source unit 10. The wavelength detection unit 1 is used, for example, for detecting a part of the light output from the light source 11 and detecting wavelength information of the light, as in a light generation unit 1A (see FIG. 3) to be described later. Further, in the light generation unit 1A to be described later, a center wavelength of the light output from the light source 11 is feedback-controlled on the basis of the detected wavelength information, but first, a configuration up to detection of the wavelength information will be described with reference to FIG. 1.

The wavelength detection unit 1 includes a polarizing plate 2, a bandpass filter 3, a lens 4, an optical fiber coupler 5 (optical element), a reflection sensor 60 (first point sensor), a transmission sensor 70 (second point sensor), and a processing unit 80.

The light source unit 10 includes the light source 11 and a power supply (not illustrated) that operates the light source 11, and outputs light having a predetermined center wavelength. The light source **11** is, for example, a monochromatic/narrow-band light source whose wavelength can be varied. Alternatively, the light source **11** may be a plurality of laser light sources with different wavelengths or an SLD/LED, or may include a white light source and a bandpass filter. Light emitted from the light source **11** passes through the polarizing plate 2, the bandpass filter 3, and the lens 4 in that order and reaches a fiber end 20a of an optical fiber 20 (first optical fiber) constituting the optical fiber coupler 5.

The polarizing plate 2 is configured, for example, to align a direction in which light vibrates when the optical fiber coupler 5 having polarization dependency is used. The bandpass filter 3 is a filter that transmits only light of a specific wavelength. The lens 4 is a lens that focuses the light transmitted through the bandpass filter 3 in a direction of the fiber end 20a of the optical fiber 20 described above.

The optical fiber coupler 5 is an optical element that separates light whose wavelength is to be measured. The optical fiber coupler 5 is, for example, a wavelength division multiplexing (WDM) coupler. The optical fiber coupler 5 is made, for example, by heating and melting a plurality of optical fibers, and then fusing and stretching them. Here, the optical fiber coupler 5 will be described as being made by fusing and stretching two optical fibers 20 and 30.

The optical fiber coupler 5 includes the optical fiber 20 (first optical fiber) and an optical fiber 30 (second optical fiber). The optical fiber 20 is an optical fiber capable of propagating light having a predetermined center wavelength. The optical fiber 20 propagates light incident from the fiber end 20a through lens 4. A fiber Bragg grating 40 is provided on the fiber end 20a side of the optical fiber 20. The fiber Bragg grating 40 is configured to reflect or transmit only light of a specific wavelength propagating in the optical fiber. When the fiber Bragg grating 40 is provided, only light whose center wavelength is within a predetermined range is propagate in the optical fiber 20, and light containing spectra outside a measurement target is excluded. Further, a bandpass filter may be provided in place of the fiber Bragg grating 40.

The optical fiber 30 is an optical fiber having a coupling region 50 that is coupled to the optical fiber 20. In the optical fiber coupler 5, light transmitted in the coupling region 50 is output from the optical fiber 30, and light reflected in the coupling region 50 is output from the optical fiber 20. The light propagating through the optical fiber 20 is detected by the reflection sensor 60. The light propagating through the optical fiber 30 is detected by the transmission sensor 70. Further, a fiber end on a side opposite to the transmission sensor 70 side in the optical fiber 30 is non-reflective termination.

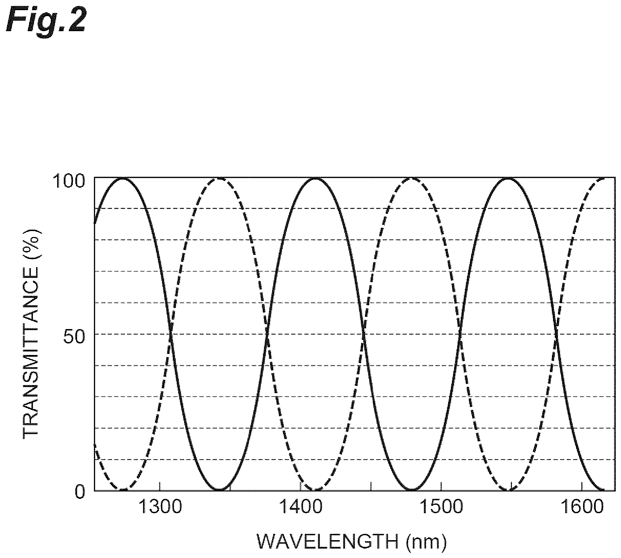

FIG. 2 is a diagram showing an example of wavelength characteristics of the optical fiber coupler 5. In FIG. 2, the horizontal axis represents a wavelength, and the vertical axis represents a transmittance (or reflectance). In FIG. 2, the solid line indicates a transmittance for each wavelength and the broken line indicates a reflectance for each wavelength. As shown in FIG. 2, the transmittance and reflectance form sine curves in opposite phases with respect to the wavelength. A period of such a sine curve and a value of the wavelength at which the transmittance (and reflectance) becomes 50% can be designed. Here, in a range in which a relationship between the wavelength and the transmittance (and the reflectance) is close to linear (can be regarded as linear) in the sine curve of the wavelength characteristics, wavelength information can be derived with high accuracy on the basis of the transmittance and reflectance. Therefore, a center wavelength of the light allowed to propagate through the optical fiber 20 described above is, for example, a wavelength at which a transmittance in the coupling region 50 is within a range of 10% to 90%. Also, the center wavelength of the light allowed to propagate through the optical fiber 20 may be a wavelength at which the transmittance in the coupling region 50 is within a range of 15% to 85%, or may be a wavelength at which the transmittance in the coupling region 50 is within a range of 20% to 80%. The optical fiber coupler 5 transmits and reflects light according to the wavelength in the coupling region 50, thereby separating the light to the optical fiber 20 side and the optical fiber 30 side.

Returning to FIG. 1, the reflection sensor 60 is a point sensor optically coupled to the optical fiber 20 of the optical fiber coupler 5. The reflection sensor 60 is connected to a downstream fiber end of the optical fiber 20. The reflection sensor 60 detects light that has been reflected in the coupling region 50 and propagated through the optical fiber 20. The reflection sensor 60 outputs a signal related to the detected light to the processing unit 80.

The transmission sensor 70 is a point sensor optically coupled to the optical fiber 30 of the optical fiber coupler 5. The transmission sensor 70 is connected to a downstream fiber end of the optical fiber 30. The transmission sensor 70 detects light that has transmitted through the coupling region 50 and propagated through the optical fiber 30. The transmission sensor 70 outputs a signal related to the detected light to the processing unit 80.

The processing unit 80 is a computer, and is physically configured to include a memory such as a RAM and a ROM, a processor (arithmetic circuit) such as a CPU, a communication interface, and a storage unit such as a hard disk. The processing unit 80 functions by executing a program stored in the memory using the CPU of the computer system. The processing unit 80 may be configured using a microcontroller or an FPGA.

The processing unit 80 derives and outputs wavelength information (specifically, a center wavelength) of the light output from the light source 11 on the basis of the signal output from reflection sensor 60 and the signal output from the transmission sensor 70. The wavelength information derived by processing unit 80 may be used for feedback control of the center wavelength of the light output from the light source 11 as will be described later.

The center wavelength (WLC: WaveLengthCenter) is derived by the following expression (1). In the expression described below, transmitted light is denoted by T, reflected light is denoted by R, a total light quantity is denoted by A, a wavelength is denoted by $\lambda$, and a spectrum is denoted by f($\lambda$).

[Math. 1]

$$WLC = \frac{\int \lambda f(\lambda) d\lambda}{\int f(\lambda) d\lambda} = \frac{\int \lambda f(\lambda) d\lambda}{A} \quad \cdot \quad \cdot \quad \cdot \quad \cdot \quad (1)$$

Now, a value of the spectrum f($\lambda$) is unknown. Considering a wavelength range $\lambda 1$ to $\lambda 2$ in which the relationship between the wavelength and the transmittance (and the reflectance) is close to linear (can be regarded as linear) in the sine curve of the wavelength characteristics of the optical fiber coupler 5, expression (1) is expressed by the following expression (2), and furthermore, from the relationship between the total light quantity A, the transmitted light T, and the reflected light R, the following expression (3) can be derived.

[Math. 2]

$$WLC = \frac{\int_{\lambda_1}^{\lambda_2} \lambda f(\lambda) d\lambda}{\int_{\lambda_1}^{\lambda_2} f(\lambda) d\lambda} = \frac{\int_{\lambda_1}^{\lambda_2} \lambda f(\lambda) d\lambda}{A} \quad \cdot \quad \cdot \quad \cdot \quad \cdot \quad (2)$$

[Math. 3]

$$A = T + R = \int_{\lambda_1}^{\lambda_2} f(\lambda) d\lambda \cdot \quad \cdot \quad \cdot \quad \cdot \quad (3)$$

A transmittance t($\lambda$) and a reflectance r($\lambda$) are expressed by expression (4) and expression (5) below. Therefore, the transmitted light T and the reflected light R are expressed by expression (6) and expression (7) below.
[Math. 4]

$$t(\lambda) = \frac{\lambda - \lambda_1}{\lambda_2 - \lambda_1} \cdot \quad \cdot \quad \cdot \quad \cdot \quad (4)$$

[Math. 5]

$$r(\lambda) = \frac{\lambda_2 - \lambda}{\lambda_2 - \lambda_1} \cdot \quad \cdot \quad \cdot \quad \cdot \quad (5)$$

[Math. 6]

$$T = \int_{\lambda_1}^{\lambda_2} t(\lambda) f(\lambda) d\lambda = \int_{\lambda_1}^{\lambda_2} \frac{\lambda - \lambda_1}{\lambda_2 - \lambda_1} f(\lambda) d\lambda \cdot \quad \cdot \quad \cdot \quad \cdot \quad (6)$$

[Math. 7]

$$R = \int_{\lambda_1}^{\lambda_2} r(\lambda) f(\lambda) d\lambda = \int_{\lambda_1}^{\lambda_2} \frac{\lambda_2 - \lambda}{\lambda_2 - \lambda_1} f(\lambda) d\lambda \cdot \quad \cdot \quad \cdot \quad \cdot \quad (7)$$

From the above, the center wavelength WLC is calculated by the following expression. (T-R)/(T+R) is defined as a wavelength shift parameter.
[Math. 8]

$$\frac{T - R}{T + R} = \frac{T - R}{A}$$

$$= \frac{\int_{\lambda_1}^{\lambda_2} \frac{2\lambda - (\lambda_1 + \lambda_2)}{\lambda_2 - \lambda_1} f(\lambda) d\lambda}{A}$$

$$= \frac{\int_{\lambda_1}^{\lambda_2} \frac{2(\lambda - \lambda_{50\%})}{\lambda_2 - \lambda_1} f(\lambda) d\lambda}{A}$$

$$= \frac{\frac{2}{\lambda_2 - \lambda_1} \left\{ \int_{\lambda_1}^{\lambda_2} \lambda f(\lambda) d\lambda - \lambda_{50\%} \int_{\lambda_1}^{\lambda_2} f(\lambda) d\lambda \right\}}{A}$$

$$= \frac{2}{\lambda_2 - \lambda_1} (WLC - \lambda_{50\%}) \cdot \quad \cdot \quad \cdot \quad \cdot \quad (8)$$

[Math. 9]

$$WLC = \frac{\lambda_2 - \lambda_1}{2}\left(\frac{T-R}{T+R}\right) + \lambda_{50\%} \quad \cdots \quad (9)$$

Since the above-described wavelength shift parameter is derived by a simple calculation, it is easy to implement it using an analog circuit. As illustrated in FIG. 3, when such an analog circuit is combined with a light source, it is possible to create a light generation unit having feedback for stabilizing a wavelength.

FIG. 3 is a diagram schematically showing the light generation unit 1A including the wavelength detection unit 1 shown in FIG. 1. As illustrated in FIG. 3, the light generation unit 1A includes the light source unit 10, and the optical fiber coupler 5 (optical element), the reflection sensor 60 (first point sensor), and the transmission sensor 70 (second point sensor) which are components of the wavelength detection unit 1. Further, although illustration is omitted, the light generation unit 1A may include other components such as the polarizing plate 2 included in the wavelength detection unit 1. In addition, the light generation unit 1A includes an optical fiber 180, a coupler 110, and an analog feedback circuit 150 (control unit). The light source unit 10, the wavelength detection unit 1, and the analog feedback circuit 150 described above may be configured as a photonic integrated circuit.

In the light generation unit 1A, light emitted from the light source unit 10 is propagated into the optical fiber 180. The coupler 110 branching light is provided in the optical fiber 180. The coupler 110 branches the input light so that the branching ratio is, for example, output light:light for wavelength detection = 90:10. The light for wavelength detection here refers to light for detecting the wavelength to perform feedback control of the center wavelength The light for wavelength detection is divided into reflected light and transmitted light in the coupling region 50 of the optical fiber coupler 5, and the reflected light is detected by the reflection sensor 60 and the transmitted light is detected by the transmission sensor 70.

The analog feedback circuit 150 controls a center wavelength of the light output from the light source unit 10 on the basis of the signal output from the reflection sensor 60 and the signal output from the transmission sensor 70. The analog feedback circuit 150 may be a circuit that derives the center wavelength of the light on the basis of the signal output from the reflection sensor 60 and the signal output from the transmission sensor 70, and performs feedback control of the center wavelength. The analog feedback circuit 150 may control the center wavelength of the light emitted from the light source 11 by controlling, for example, a current output by a power supply circuit 18 (power supply) that operates the light source 11. Further, when the wavelength is adjusted (changed) by varying a current, since brightness of the light itself will be shifted, light quantity control may be performed by controlling the ON time (duty control or PWM control). Also, in place of the analog feedback circuit 150, the feedback control may be performed by a digital calculation.

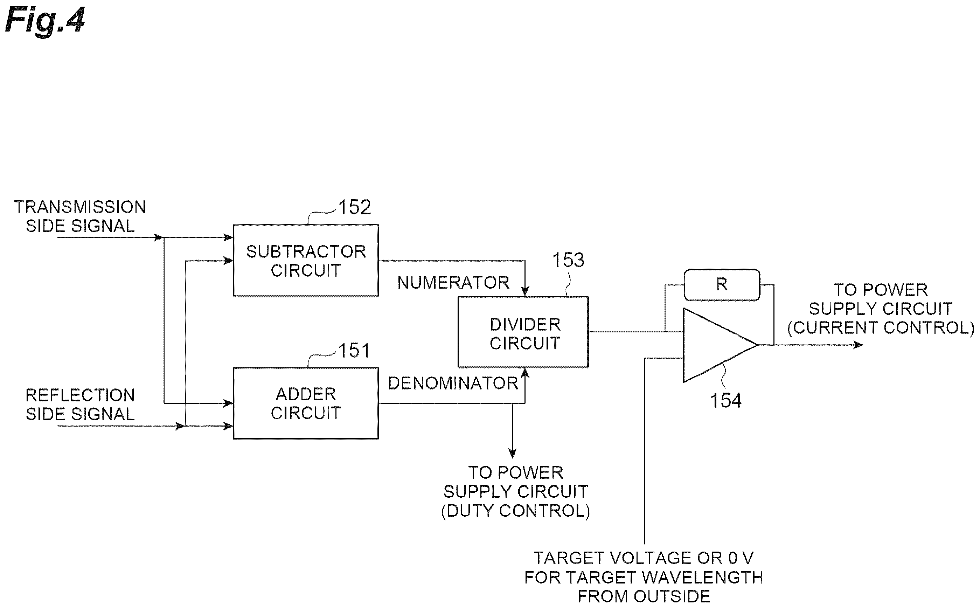

FIG. 4 is a diagram showing an example of the analog feedback circuit 150. If the wavelength shift parameter (T-R)/(T+R) is derived as shown in expression (9) described above, the center wavelength WLC of the light can be derived. The analog feedback circuit 150 includes an adder circuit 151, a subtractor circuit 152, a divider circuit 153, and a comparator 154.

The adder circuit 151 is an adder circuit that adds the signal output from the transmission sensor 70 (that is, the transmitted light T) and the signal output from the reflection sensor 60 (that is, the reflected light R) to output T+R. When the added signal, T+R, is output to the power supply circuit 18, duty control is performed on the basis of T+R, and the light quantity (intensity) is feedback-controlled (adjusted). The subtractor circuit 152 is a subtractor circuit that subtracts the signal output from the reflection sensor 60 (that is, the reflected light R) from the signal output from the transmission sensor 70 (that is, the transmitted light T) to output T-R.

The divider circuit 153 is a circuit that derives the wavelength shift parameter, (T-R)/(T+R), by dividing T-R input from the subtractor circuit 152 by T+R input from the adder circuit 151. The divider circuit 153 outputs the wavelength shift parameter to the comparator 154.

The comparator 154 compares the signal input from the divider circuit 153 with a target voltage (or 0 V) for a target wavelength input from the outside, and outputs a signal according to the comparison to the power supply circuit 18. Thereby, the current output from the power supply circuit 18 that operates the light source 11 is controlled, and the center wavelength of the light emitted from the light source 11 is controlled. Further, the control of the center wavelength of the light emitted from the light source 11 may be performed, for example, by adjusting a current flowing through a Peltier element that controls a temperature of an LD element serving as the light source 11.

Next, operations and effects of the optical fiber coupler 5, the wavelength detection unit 1, and the light generation unit 1A according to the present embodiment will be described.

The optical fiber coupler 5 of the present embodiment is an optical element for separating light whose wavelength is to be measured, and includes the optical fiber 20 capable of propagating light having a predetermined center wavelength and the optical fiber 30 having the coupling region 50 that is coupled to the optical fiber 20, in which the center wavelength of the light allowed to propagate through the optical fiber 20 is a wavelength at which a transmittance in the coupling region 50 is within a range of 10% to 90%, and the light is transmitted and reflected according to the wavelength in the coupling region 50.

In the optical fiber coupler 5 of the present embodiment, the optical fiber 20 and the optical fiber 30 are coupled in the coupling region, and the transmittance of the center wavelength of the light propagated through the optical fiber 20 in the coupling region 50 is set within a range of 10% to 90%, and the light is transmitted and reflected in the coupling region 50 according to the wavelength. In this way, when the center wavelength of the light propagated through the optical fiber 20 is set to a wavelength at which the transmittance in the coupling region 50 is within the range of 10% to 90%, and the light is transmitted and reflected in the coupling region 50 according to the wavelength, the light is separated into the optical fiber 20 side and the optical fiber 30 side according to the wavelength. According to such a configuration, since the light separated according to the wavelength propagates through the optical fiber 20 side and the optical fiber 30 side, respectively, wavelength information can be appropriately derived by, for example, measuring the light on the optical fiber 20 side and the light on the optical fiber 30 side. Then, in this method of deriving wavelength information on the basis of the light separated by such an optical fiber coupler 5, it is possible to derive the wavelength information regardless of a shape of the spectrum, for example, even for light whose spectrum does not have a plurality of peaks, or the like. As described above, according to the optical fiber coupler 5 of the present embodiment, it is possible to appropriately derive wavelength information of various types of light regardless of a shape of the spectrum. Also, since a spectrometer is not required to derive wavelength information, it is possible to derive the wavelength information at a low cost.

The center wavelength of the light allowed to propagate through the optical fiber 20 may be a wavelength at which the transmittance in the coupling region 50 is within a range of 15% to 85%, In the optical fiber coupler 5 in which the two optical fibers 20 and 30 have the coupling region 50 as described above, a relationship between the wavelength and the transmittance (and the reflectance) is shown by a sine curve in a graph in which, for example, the horizontal axis represents the wavelength and the vertical axis represents the transmittance (and the reflectance). In such a sine curve, the wavelength information is appropriately derived on the basis of the transmittance and reflectance in a range in which the relationship is approximately linear. In this regard, for example, if the transmittance is within the wavelength range of 15% to 85%, a slope of the sine curve in that range is more than half of a slope of the sine curve when the transmittance is 50%, and therefore, the above-described relationship becomes relatively linear, allowing wavelength information to be derived with high accuracy.

The center wavelength of the light allowed to propagate through the optical fiber 20 may be a wavelength at which the transmittance in the coupling region 50 is within a range of 20% to 80%. According to such a configuration, the wavelength information can be derived with higher accuracy in a range in which the relationship between the transmittance (and the reflectance) and the wavelength is more linear.

The wavelength detection unit 1 according to the present embodiment includes the optical fiber coupler 5 described above, the reflection sensor 60 optically coupled to the optical fiber 20 of the optical fiber coupler 5, and the transmission sensor 70 optically coupled to the optical fiber 30 of the optical fiber coupler 5. In this way, when the reflection sensor 60 or the transmission sensor 70 are optically coupled to each of the optical fibers 20 and 30, light transmitted through and light reflected from the coupling region 50 can be accurately detected at the respective points.

The wavelength detection unit 1 may further include the processing unit 80 that derives and outputs wavelength information on the basis of the signal output from the reflection sensor 60 and the signal output from the transmission sensor 70. According to such a configuration, wavelength information can be derived with high accuracy on the basis of information on the transmitted light and reflected light detected with high accuracy at the respective points.

The light generation unit 1A according to the present embodiment includes the light source unit 10 having the light source 11 and the power supply circuit 18 that operates the light source 11 and outputting light with a predetermined center wavelength, a wavelength detection unit 1 optically coupled to the light source 11 by the optical fiber 20, and the analog feedback circuit 150 that controls a center wavelength of the light output from the light source unit 10 on the basis of the signal output from the reflection sensor 60 and the signal output from the transmission sensor 70. In this way, when the center wavelength of the light output from the light source unit 10 is controlled on the basis of information on the transmitted light and reflected light detected with high accuracy at the respective points, the center wavelength of the light output from the light source unit 10 can be adjusted with high accuracy from the actually measured information on the transmitted light and reflected light. Thereby, for example, the quality of a monochromatic light source can ensured.

The analog feedback circuit 150 may be a circuit that performs feedback control of the center wavelength on the basis of the signal output from the reflection sensor 60 and the signal output from the transmission sensor 70. When the feedback control is performed in this way, actually measured information on the transmitted light and reflected light can be appropriately reflected in the adjustment of the center wavelength, thereby further improving an adjustment accuracy of the center wavelength.

The light source unit 10, the wavelength detection unit 1, and the analog feedback circuit 150 may be configured as a photonic integrated circuit. Thereby, the configuration relating to the light generation unit 1A can be made small in size.

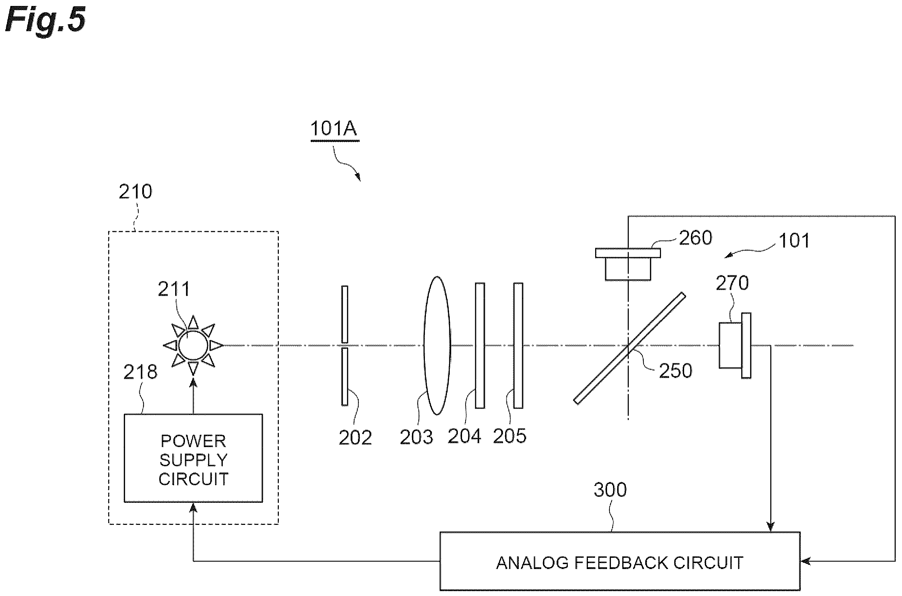

Although the present embodiment has been described above, the present disclosure is not limited to the above embodiment. For example, the configuration of the wavelength detection unit and the light generation unit including the wavelength detection unit is not limited to the configuration described above, and may be, for example, configured as shown in FIG. 5.

FIG. 5 is a diagram schematically showing a light generation unit 101A according to a modified example. The light generation unit 101A includes a light source unit 210, a wavelength detection unit 101, and an analog feedback circuit 300.

The light source unit 210 includes, for example, a light source 211 similar to the light source 11 described above and a power supply circuit 218 similar to the power supply circuit 18 described above. Also, the analog feedback circuit 300 (processing unit, control unit) may, for example, have the same configuration as the analog feedback circuit 150 described above.

The wavelength detection unit 101 includes a pinhole 202, a lens 203, a bandpass filter 204, a wave plate 205, an tilted dichroic mirror 250, a reflection sensor 260 (second point sensor), and a transmission sensor 270 (first point sensor). Light emitted from the light source unit 210 reaches the pinhole 202, the lens 203, the bandpass filter 204, the wave plate 205, and the tilted dichroic mirror 250 in that order.

The pinhole 202 is provided to prevent an incident angle of light to the tilted dichroic mirror 250 from varying (deviating). Even in a configuration using the tilted dichroic mirror 250, a center wavelength of light is determined by the above-described expression (9) as will be described later, but if the incident angle of the light to the tilted dichroic mirror 250 varies, $\lambda 50\%$ in expression (9) may deviate and an accuracy of deriving the center wavelength may deteriorate. $\lambda 50\%$ is a wavelength at which a transmittance and a reflectance of the tilted dichroic mirror 250 are equal. In this regard, the use of pinhole 202 prevents the incident angle of light to the tilted dichroic mirror 250 from varying (deviating). Further, the light incident on the tilted dichroic mirror 250 may be made into parallel light by some configuration other than the pinhole 202.

The wave plate 205 is a wave plate provided in accordance with polarization dependence of the tilted dichroic mirror 250. The wave plate 205 may be, for example, a $\lambda/4$ wave plate effective in an observation wavelength band when the incident light is not unpolarized.

The tilted dichroic mirror 250 is a mirror fabricated using a special optical material and separates light (light input from a first optical path) that has reached it from the light source unit 210 through the pinhole 202, the lens 203, the bandpass filter 204, and the wave plate 205 by transmitting or reflecting the light according to the wavelength. The tilted dichroic mirror 250, for example, reflects light of a specific wavelength and transmits light of other wavelengths.

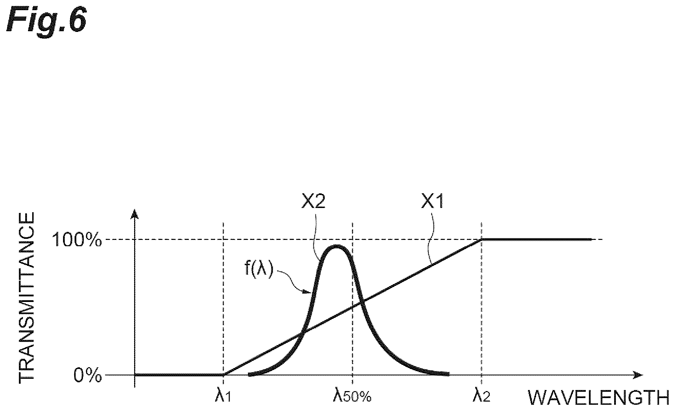

FIG. 6 is a diagram showing an example of a spectrum of light and wavelength characteristics of the tilted dichroic mirror 250. In FIG. 6, the horizontal axis represents a wavelength, and the vertical axis represents a spectral intensity (in a case of the spectrum of light) and a transmittance (in a case of the tilted dichroic mirror 250). As shown by the characteristic X1 of the tilted dichroic mirror 250 in FIG. 6, in the tilted dichroic mirror 250, in a specific wavelength band (wavelength band from $\lambda 1$ to $\lambda 2$), a transmittance (and reflectance) of light changes gradually according to changes in wavelength, and in wavelength bands other than the specific wavelength band (that is, on a shorter wavelength side than the wavelength $\lambda 1$ and on a longer wavelength side than the wavelength $\lambda 2$), a transmittance (and reflectance) of light is constant regardless of changes in wavelength. That is, the tilted dichroic mirror 250 exhibits a monotonic change in transmittance and reflectance with respect to the wavelength within a predetermined wavelength range. The phrase "a transmittance of light is constant regardless of changes in wavelength" includes not only a case in which it is completely constant, but also a case in which, for example, a change in transmittance with respect to a wavelength change of 1 nm is 0.1% or less. On a shorter wavelength side than the wavelength $\lambda 1$, the transmittance of light is approximately 0% regardless of changes in wavelength, and on a longer wavelength side than the wavelength $\lambda 2$, the transmittance of light is approximately 100% regardless of changes in wavelength. Further, the phrase "the transmittance of light is approximately 0%" includes a transmittance of about 0%+10%, and "the transmittance of light is approximately 100%" includes a transmittance of about 100%- 10%. As shown by the waveform X2 of the spectrum $f(\lambda)$ of the incident light in FIG. 6, it is assumed that the spectrum $f(\lambda)$ of the incident light lies between the wavelength $\lambda 1$ and the wavelength $\lambda 2$. When such a tilted dichroic mirror 250 is used, expressions (1) to (9) described above hold true as in the embodiment, and the center wavelength is derived by expression (9).

The transmission sensor 270 is a point sensor that detects light transmitted through the tilted dichroic mirror 250. The reflection sensor 260 is a point sensor that detects light reflected by the tilted dichroic mirror 250 into a second optical path different from the first optical path described above.

The analog feedback circuit 300 derives wavelength information (specifically, the center wavelength) on the basis of a signal output from the transmission sensor 270 and a signal output from the reflection sensor 260. The center wavelength is derived by expression (9) described above. The analog feedback circuit 300 performs feedback control of the center wavelength of the light output from the light source unit 210 on the basis of the signal output from the transmission sensor 270 and the signal output from the reflection sensor 260. The analog feedback circuit 300 may control the center wavelength of the light emitted from the light source 211 by, for example, controlling a current output by the power supply circuit 218 (power supply) that operates the light source 211.

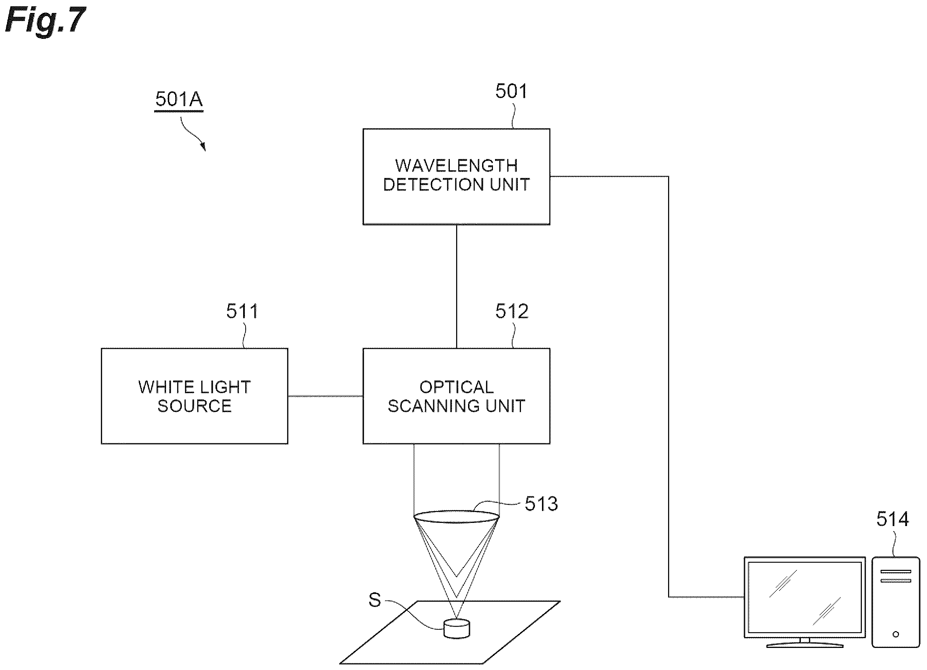

FIGS. 7 to 11 are diagrams each showing an application example of a wavelength detection unit. In the example shown in FIG. 7, a wavelength detection unit 501 is incorporated into a height measurement apparatus 501A for measuring a height of a sample S. The wavelength detection unit 501 may have the same configuration as the wavelength detection unit 1 or the wavelength detection unit 101 described above. The height measurement apparatus 501A includes the wavelength detection unit 501, a white light source 511, an optical scanning unit 512, a chromatic aberration lens 513, and a control unit 514.

The white light source 511 is a white light source that outputs white light containing various wavelength components. The optical scanning unit 512 scans the white light from the white light source 511 in a direction of the sample S. The sample S here may be, for example, placed and immobile. The optical scanning unit 512 may be, for example, a galvanometer mirror or a micro electro mechanical systems (MEMS) mirror. Although not shown in the figure, stage scanning in which the sample S is moved, instead of scanning the light, may also be employed. The chromatic aberration lens 513 is provided between the optical scanning unit 512 and the sample S. The light that has passed through the chromatic aberration lens 513 has its focal position shifted in an optical axis direction for each wavelength due to chromatic aberration. That is, the light focused on the sample S after passing through the chromatic aberration lens 513 has a different focal position in a height direction for each wavelength. Therefore, a height of the sample S can be derived by analyzing wavelength components of light reflected from the sample S.

The wavelength detection unit 501 detects the light reflected from the sample S and derives wavelength information on the basis of a signal output from the first point sensor (not shown) described above and a signal output from the second point sensor (not shown) described above. The wavelength detection unit 501 may output the derived wavelength information to the control unit 514, or may output information related to the signals from the first point sensor and the second point sensor to the control unit 514.

The control unit 514 derives a center wavelength (centroid wavelength) of the light reflected from the sample S on the basis of the information from the wavelength detection unit 501. As described above, since the light focused on the sample S has a focal position in the height direction that differs for each wavelength, when the center wavelength of the light reflected from the sample S is derived in the control unit 514, it is possible to obtain height information of the sample S on the basis of the information of the center wavelength. In addition to (or instead of) the height of the sample S, the control unit 514 may determine a three-dimensional shape of the sample S from the center wavelength information.

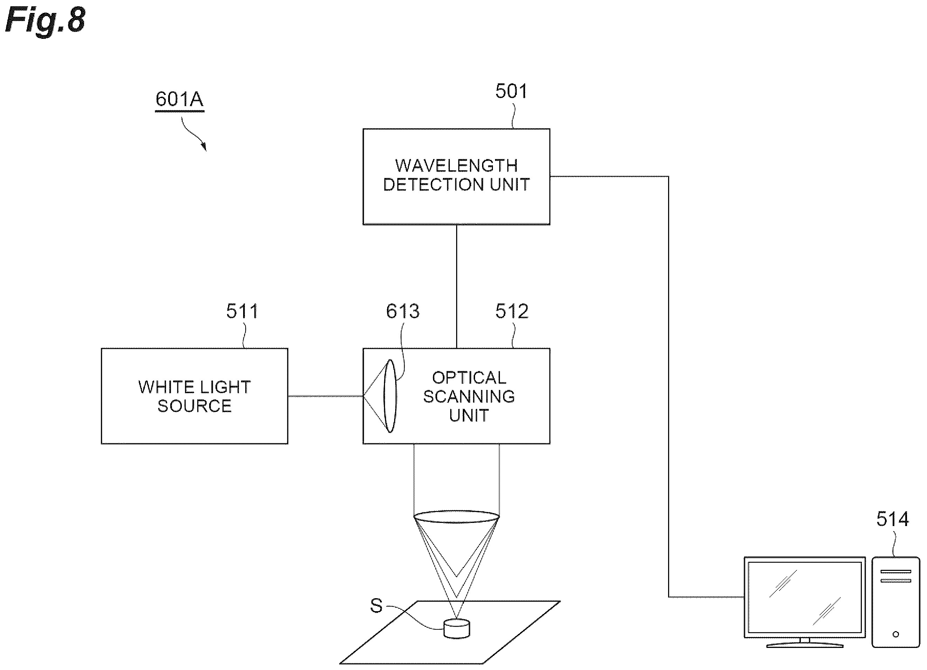

A height measurement apparatus 601A shown in FIG. 8 includes, similarly to the height measurement apparatus 501A, the wavelength detection unit 501, the white light source 511, the optical scanning unit 512, and the control unit 514. The height measurement apparatus 601A also includes a chromatic aberration lens 613. The chromatic aberration lens 613 has, for example, the same configuration as the chromatic aberration lens 513 described above, but is provided at a different position from that of the chromatic aberration lens 513. The chromatic aberration lens 613 is provided at a portion of the optical scanning unit 512 through which the white light is input. The chromatic aberration lens 613 in this case may be, for example, a collimator. In such a configuration, there is no need to generate chromatic aberration in an objective lens, and therefore existing expensive and high-precision objective lenses can be used.

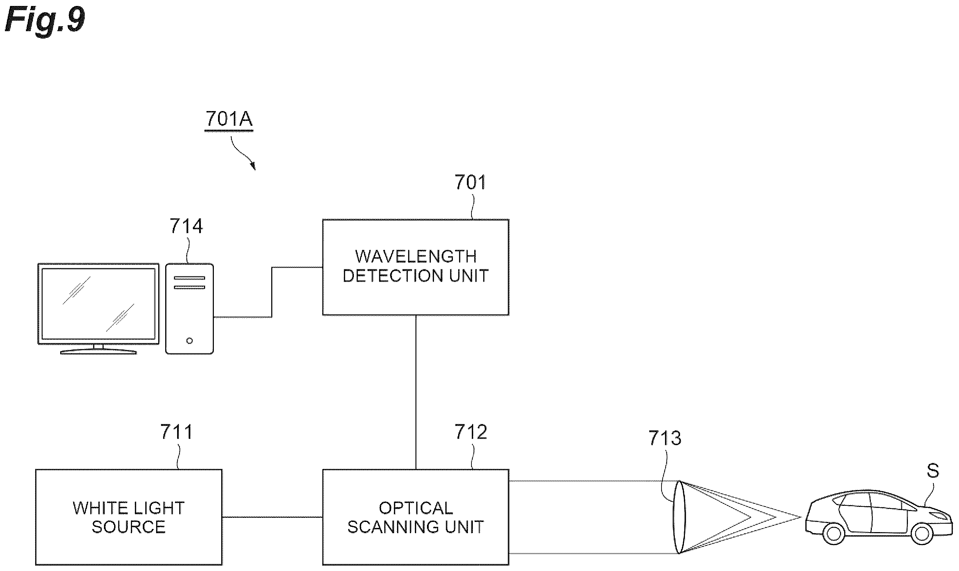

In the example shown in FIG. 9, a wavelength detection unit 701 is incorporated into a distance measurement apparatus 701A for measuring a distance to the sample S. The wavelength detection unit 701 may have the same configuration as the wavelength detection unit 1 or wavelength detection unit 101 described above. The distance measurement apparatus 701A includes the wavelength detection unit 701, a white light source 711, an optical scanning unit 712, a chromatic aberration lens 713, and a control unit 714.

The white light source 711 is a white light source that outputs white light containing various wavelength components. The optical scanning unit 712 scans the white light from the white light source 711 in a direction of the sample S. The sample S here may be, for example, a moving object (such as a vehicle). The chromatic aberration lens 713 is provided between the optical scanning unit 712 and the sample S. The light that has passed through the chromatic aberration lens 713 has its focal position shifted in an optical axis direction for each wavelength due to chromatic aberration. Therefore, a distance to the sample S can be derived by analyzing wavelength components of light reflected from the sample S.

The wavelength detection unit 701 detects the light reflected from the sample S and derives wavelength information on the basis of a signal output from the first point sensor (not shown) described above and a signal output from the second point sensor (not shown) described above. The wavelength detection unit 701 may output the derived wavelength information to the control unit 714, or may output information related to the signals from the first point sensor and the second point sensor to the control unit 714.

The control unit 714 derives a center wavelength (centroid wavelength) of the light reflected from the sample S on the basis of the information from the wavelength detection unit 701. As described above, since the light focused on the sample S has a focal position that differs for each wavelength, when the center wavelength of the light reflected from the sample S is derived in the control unit 714, it is possible to obtain a separation distance to the sample S (distance to the sample S) on the basis of the information of the center wavelength.

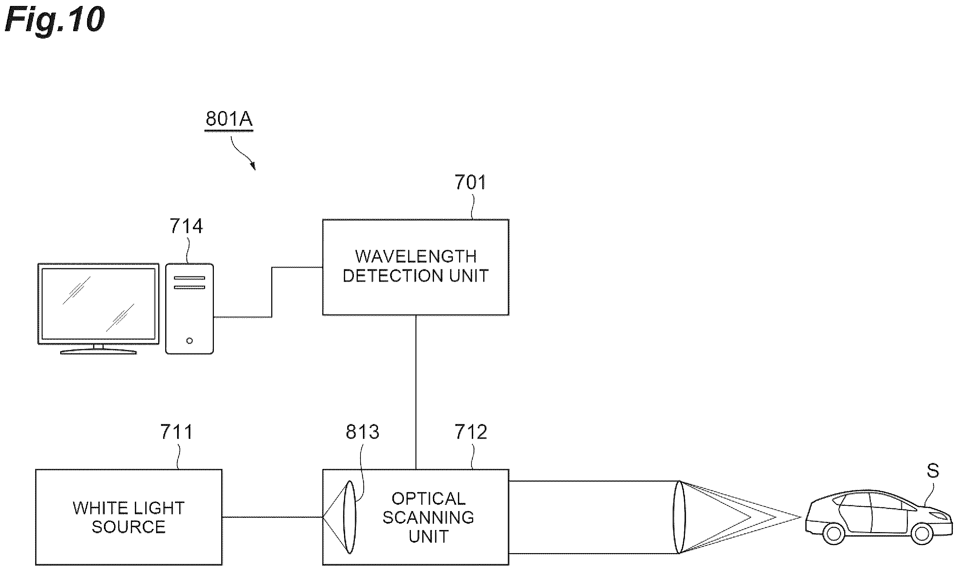

A distance measurement apparatus 801A shown in FIG. 10 includes, similarly to the distance measurement apparatus 701A, the wavelength detection unit 701, the white light source 711, the optical scanning unit 712, and the control unit 714. Also, the distance measurement apparatus 801A includes a chromatic aberration lens 813. The chromatic aberration lens 813 has, for example, the same configuration as the chromatic aberration lens 713 described above, but is provided at a different position from that of the chromatic aberration lens 713. The chromatic aberration lens 813 is provided at a portion of the optical scanning unit 712 through which the white light is input. The chromatic aberration lens 813 in this case may be, for example, a collimator. In such a configuration, there is no need to generate chromatic aberration in a telephoto lens system, and therefore existing expensive and high-precision telephoto lenses or reflecting mirrors can be used.

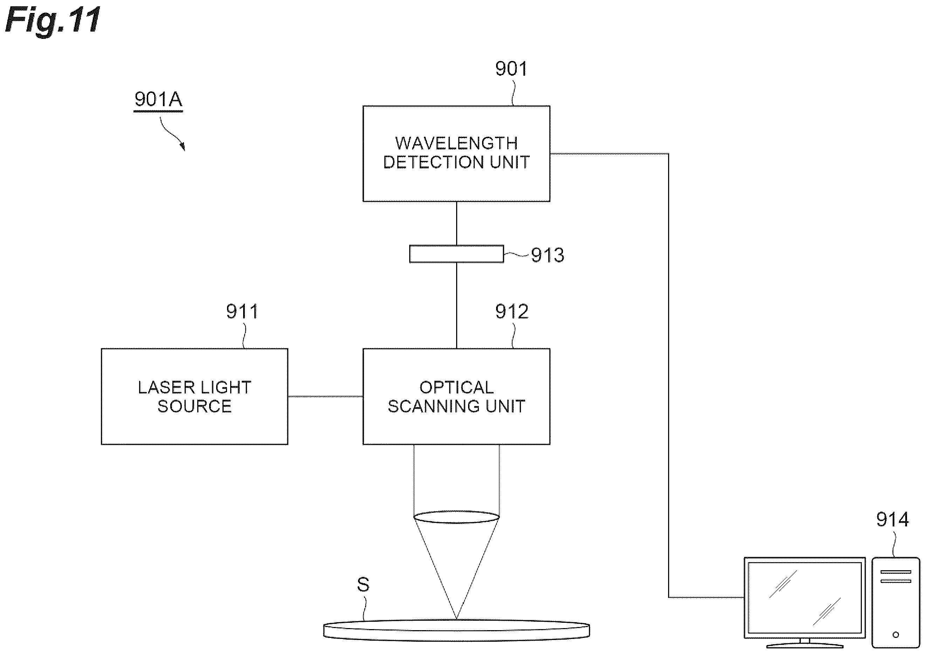

In the example shown in FIG. 11, a wavelength detection unit 901 is incorporated into a measurement apparatus 901A that determines a stress of the sample S (for example, a wafer) from a center wavelength of Raman scattered light. The stress of the sample S here refers to tensile strain and compressive strain that occur and are observed on a surface of the sample S. Generally, a film is formed at high temperature on a surface during a wafer fabrication process. Since a coefficient of linear expansion of this film is generally different from that of a substrate, stress is generated on the basis of a difference in coefficient of linear expansion during the process of returning to room temperature. The wavelength detection unit 901 may have the same configuration as the wavelength detection unit 1 or wavelength detection unit 101 described above. The measurement apparatus 901A includes the wavelength detection unit 901, a laser light source 911, an optical scanning unit 912, an excitation light cut filter 913, and a control unit 914.

The laser light source 911 is a light source that outputs laser light (such as visible light, near-infrared light, or the like). The optical scanning unit 912 scans the laser light (excitation light) from the laser light source 911 in a direction of the sample S. The sample S here may be, for example, a wafer. The excitation light cut filter 913 is provided between the optical scanning unit 912 and the wavelength detection unit 901, and is a filter that cuts excitation light, which is light other than scattered light generated by Raman scattering among the light from sample S. As the excitation light cut filter 913, for example, a dichroic mirror, a notch filter, or the like may be used.

The wavelength detection unit 901 detects light other than the light cut by the excitation light cut filter 913, that is, Raman scattered light, among the light from the sample S, and derives wavelength information on the basis of a signal output from the first point sensor (not shown) described above and a signal output from the second point sensor (not shown) described above. The wavelength detection unit 901 may output the derived wavelength information to the control unit 914, or may output information related to the signals from the first point sensor and the second point sensor to the control unit 914.

The control unit 914 derives a center wavelength (centroid wavelength) of the Raman scattered light on the basis of the information from the wavelength detection unit 901. The control unit 914 determines, for example, a stress of the sample S by analyzing a shift amount thereof from the center wavelength of the Raman scattered light. Generally, the Raman scattered light of Si is 520 Kaiser, but since it is known that a stress of 250 MPa is applied for each shift of 1 Kaiser, a shift amount of the center wavelength from a stress-free wavelength can be converted into a parameter indicating the stress. Specifically, a magnitude of the stress is calculated as "Shift amount (unit: Kaiser)×250 MPa". For example, when excitation is performed with a 532 nm laser, 1 Kaiser is approximately 30 pm. In actual operation, it is necessary to observe this with a resolution of less than one-tenth of that value. It is difficult to achieve this level of resolution with a general spectrometer, but since a resolution of a wavelength shift technology is determined by an inclination of an inclined filter and an amount of light, this level of resolution can be easily achieved.

Finally, various exemplary aspects included in the present disclosure are described in [E1] to [E11] below.

[E1] An optical element, which is an optical element for separating light whose wavelength is to be measured, including:

a first optical fiber capable of propagating light having a predetermined center wavelength; and
a second optical fiber having a coupling region coupled to the first optical fiber, in which
the center wavelength of the light allowed to propagate through the first optical fiber is a wavelength at which a transmittance in the coupling region is within a range of 10% to 90%, and
the light is transmitted and reflected according to a wavelength of the light allowed to propagate through the first optical fiber in the coupling region.

[E2] The optical element according to [E1], in which the center wavelength of the light allowed to propagate through the first optical fiber is a wavelength at which a transmittance in the coupling region is within a range of 15% to 85%.

[E3] The optical element according to [E1], in which the center wavelength of the light allowed to propagate through the first optical fiber is a wavelength at which the transmittance in the coupling region is within a range of 20% to 80%,

[E4] A wavelength detection unit including:

the optical element according to any one of [E1] to [E3];
a first point sensor optically coupled to the first optical fiber of the optical element; and
a second point sensor optically coupled to the second optical fiber of the optical element.

[E5] The wavelength detection unit according to [E4], further including a processing unit that derives and outputs wavelength information on the basis of a signal output from the first point sensor and a signal output from the second point sensor.

[E6] A light generation unit including:

a light source unit having a light source and a power supply operating the light source, and configured to output light having a predetermined center wavelength;

the wavelength detection unit according to [E4] or [E5] optically coupled to the light source by the first optical fiber; and

a control unit controlling the center wavelength of the light output from the light source unit on the basis of a signal output from the first point sensor and a signal output from the second point sensor.

[E7] The light generation unit according to [E6], in which the control unit is a circuit that performs feedback control of the center wavelength on the basis of the signal output from the first point sensor and the signal output from the second point sensor.

[E8] The light generation unit according to [E6] or [E7], in which the light source unit, the wavelength detection unit, and the control unit are configured as a photonic integrated circuit.

[E9] A wavelength detection unit including:

a dichroic mirror separating light input from a first optical path by transmitting and reflecting the light according to a wavelength;

a first point sensor detecting the light transmitted through the dichroic mirror; and

a second point sensor detecting the light reflected by the dichroic mirror into a second optical path different from the first optical path, in which

the dichroic mirror exhibits a monotonic change in transmittance and reflectance with respect to the wavelength within a predetermined wavelength range.

[E10] The wavelength detection unit according to [E9], further including a processing unit that derives and outputs wavelength information on the basis of a signal output from the first point sensor and a signal output from the second point sensor.

[E11] A light generation unit including:

a light source unit having a light source and a power supply operating the light source, and outputting light having a predetermined center wavelength;

the wavelength detection unit according to [E9] or [E10], into which the light from the light source unit is input; and

a control unit controlling the center wavelength of the light output from the light source unit on the basis of a signal output from the first point sensor and a signal output from the second point sensor.

**Reference Signs List**

1, 101 Wavelength detection unit, 1A, 101A Light generation unit, 5 Optical fiber coupler (optical element), 10, 210 Light source unit, 11, 211 Light source, 18, 218 Power supply circuit (power supply), 20 Optical fiber (first optical fiber), 30 Optical fiber (second optical fiber), 50 Coupling region, 60 Reflection sensor (first point sensor), 70 Transmission sensor (second point sensor), 80 Processing unit, 150, 300...Analog feedback circuit (control unit), 250 Tilted dichroic mirror, 260 Reflection sensor (second point sensor), 270 Transmission sensor (first point sensor)

**Claims**

1. An optical element, which is an optical element for separating light whose wavelength is to be measured, comprising:

a first optical fiber allowing light having a predetermined center wavelength to propagate: and

a second optical fiber having a coupling region coupled to the first optical fiber, wherein

the center wavelength of the light allowed to propagate through the first optical fiber is a wavelength at which a transmittance in the coupling region is within a range of 10% to 90%, and

the light is transmitted and reflected according to a wavelength of the light allowed to propagate through the first optical fiber in the coupling region.

2. The optical element according to claim 1, wherein the center wavelength of the light allowed to propagate through the first optical fiber is a wavelength at which a transmittance in the coupling region is within a range of 15% to 85%.

3. The optical element according to claim 1, wherein the center wavelength of the light allowed to propagate through the first optical fiber is a wavelength at which the transmittance in the coupling region is within a range of 20% to 80%.

4. A wavelength detection unit comprising:

the optical element according to any one of claims 1 to 3;
a first point sensor optically coupled to the first optical fiber of the optical element; and
a second point sensor optically coupled to the second optical fiber of the optical element.

5. The wavelength detection unit according to claim 4, further comprising a processing unit which derives and outputs wavelength information on the basis of a signal output from the first point sensor and a signal output from the second point sensor.

6. A light generation unit comprising:

a light source unit having a light source and a power supply operating the light source, and configured to output light having a predetermined center wavelength;
the wavelength detection unit according to claim 4 optically coupled to the light source by the first optical fiber; and
a control unit controlling the center wavelength of the light output from the light source unit on the basis of a signal output from the first point sensor and a signal output from the second point sensor.

7. The light generation unit according to claim 6, wherein the control unit is a circuit that performs feedback control of the center wavelength on the basis of the signal output from the first point sensor and the signal output from the second point sensor.

8. The light generation unit according to according to claim 7, wherein the light source unit, the wavelength detection unit, and the control unit are configured as a photonic integrated circuit.

9. A wavelength detection unit comprising:

a dichroic mirror separating light input from a first optical path by transmitting and reflecting the light according to a wavelength;
a first point sensor detecting the light transmitted through the dichroic mirror; and
a second point sensor detecting the light reflected by the dichroic mirror into a second optical path different from the first optical path, wherein
the dichroic mirror exhibits a monotonic change in transmittance and reflectance with respect to the wavelength within a predetermined wavelength range.

10. The wavelength detection unit according to claim 9, further comprising a processing unit which derives and outputs wavelength information on the basis of a signal output from the first point sensor and a signal output from the second point sensor.

11. A light generation unit comprising:

a light source unit having a light source and a power supply operating the light source, and outputting light having a predetermined center wavelength;
the wavelength detection unit according to claim 9 or 10, into which the light from the light source unit is input; and
a control unit controlling the center wavelength of the light output from the light source unit on the basis of a signal output from the first point sensor and a signal output from the second point sensor.

Fig.1

# Fig.2

**Fig.3**

LIGHT OUTPUT

10

1A

11

180

110

1

20

60

18

50

5

30

70

POWER SUPPLY
CIRCUIT

ANALOG FEEDBACK CIRCUIT

150

EP 4 692 875 A1

# Fig.4

TRANSMISSION SIDE SIGNAL →

SUBTRACTOR CIRCUIT ~152

NUMERATOR →

DIVIDER CIRCUIT ~153

R

154

TO POWER SUPPLY CIRCUIT (CURRENT CONTROL) →

REFLECTION SIDE SIGNAL →

ADDER CIRCUIT ~151

DENOMINATOR →

TO POWER SUPPLY CIRCUIT (DUTY CONTROL)

TARGET VOLTAGE OR 0 V FOR TARGET WAVELENGTH FROM OUTSIDE

EP 4 692 875 A1

EP 4 692 875 A1

**Fig.5**

Fig.6

EP 4 692 875 A1

**Fig.7**

# Fig.8

601A

501 WAVELENGTH DETECTION UNIT

511 WHITE LIGHT SOURCE

613

512 OPTICAL SCANNING UNIT

S

514

EP 4 692 875 A1

# Fig.9

EP 4 692 875 A1

Fig.10

*Fig.11*

EP 4 692 875 A1

**EP 4 692 875 A1**

INTERNATIONAL SEARCH REPORT

International application No.

**PCT/JP2024/014140**

| A. | CLASSIFICATION OF SUBJECT MATTER |
| --- | --- |

*G02B 6/293*(2006.01)i; *G01J 3/12*(2006.01)i; *G02B 6/26*(2006.01)i; *G02B 6/42*(2006.01)i; *G02B 6/287*(2006.01)i; *H01S 5/0687*(2006.01)i
FI: G02B6/293; G02B6/287; G02B6/26; G02B6/42; G01J3/12; H01S5/0687

According to International Patent Classification (IPC) or to both national classification and IPC

| B. | FIELDS SEARCHED |
| --- | --- |

Minimum documentation searched (classification system followed by classification symbols)

G02B6/26-6/34; G02B6/42-6/43; G01J3/00-3/457; H01S5/00-5/50

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| X | JP 2001-24274 A (NIPPON TELEGRAPH AND TELEPHONE CORPORATION) 26 January 2001 (2001-01-26) | 1-7 |
| | paragraphs [0014]-[0048], fig. 1-5 | |
| Y | | 8 |
| X | US 5822049 A (THE UNITED STATES OF AMERICA AS REPRESENTED BY THE DIRECTOR OF THE NATIONAL SECURITY AGENCY) 13 October 1998 (1998-10-13) | 1-5 |
| | column 4, line 6 to column 5, line 44, fig. 1 | |
| Y | WO 2019/160064 A1 (THE FURUKAWA ELECTRIC CO., LTD.) 22 August 2019 (2019-08-22) | 8 |
| | paragraphs [0028], [0083]-[0085], fig. 13 | |
| X | JP 2017-75819 A (MINEBEAMITSUMI INC.) 20 April 2017 (2017-04-20) | 9-10 |
| | paragraphs [0019]-[0033], [0041], fig. 1-2, 5 | |
| Y | | 11 |

✓ Further documents are listed in the continuation of Box C.    ✓ See patent family annex.

| | | | |
| --- | --- | --- | --- |
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| **31 May 2024** | **18 June 2024** |

| Name and mailing address of the ISA/JP | Authorized officer |
| --- | --- |
| **Japan Patent Office (ISA/JP)** 3-4-3 Kasumigaseki, Chiyoda-ku, Tokyo 100-8915 Japan | |
| | Telephone No. |

Form PCT/ISA/210 (second sheet) (July 2022)

## INTERNATIONAL SEARCH REPORT

| International application No. |
| --- |
| **PCT/JP2024/014140** |

**C.    DOCUMENTS CONSIDERED TO BE RELEVANT**

| Category* | Citation of document, with indication, where appropriate, of the relevant passages | Relevant to claim No. |
| --- | --- | --- |
| Y | JP 2003-163400 A (SHIMADZU CORPORATION) 06 June 2003 (2003-06-06) paragraphs [0012]-[0013], fig. 1-2 | 11 |
| A | JP 2002-202190 A (ANDO ELECTRIC CO., LTD.) 19 July 2002 (2002-07-19) entire text, all drawings | 1-11 |

Form PCT/ISA/210 (second sheet) (July 2022)

**INTERNATIONAL SEARCH REPORT**
Information on patent family members

International application No.

**PCT/JP2024/014140**

| Patent document cited in search report | | | Publication date (day/month/year) | Patent family member(s) | Publication date (day/month/year) |
|---|---|---|---|---|---|
| JP | 2001-24274 | A | 26 January 2001 | (Family: none) | |
| US | 5822049 | A | 13 October 1998 | (Family: none) | |
| WO | 2019/160064 | A1 | 22 August 2019 | US 2020/0373735 A1<br>paragraphs [0031], [0106]-<br>[0111], fig. 13<br>CN 111712980 A | |
| JP | 2017-75819 | A | 20 April 2017 | (Family: none) | |
| JP | 2003-163400 | A | 06 June 2003 | (Family: none) | |
| JP | 2002-202190 | A | 19 July 2002 | US 2002/0080367 A1<br>entire text, all drawings | |

Form PCT/ISA/210 (patent family annex) (July 2022)

**EP 4 692 875 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2016129207 A